# EUROPEAN PATENT APPLICATION

(11) **EP 4 797 310 A1**
(43) Date of publication of application: **26.08.2026**
(21) Application number: 24895481.0
(22) Date of filing: 27.05.2024
(51) Int. Cl.: H01J 37/147

(54) **ENERGY REGULATION AND DEFLECTION ASSEMBLY, AND ION IMPLANTER**

(30) Priority: 27.11.2023 CN 202311591554
(71) Applicant: Qingdao SRI Intellectual Technology Co., Ltd., Qingdao, Shandong 266000 (CN)
(72) Inventor: NIE, Xiang, Beijing Road, China (Shandong) Pilot Free Trade Zone Qingdao Area Qingdao, Shandong 266000 (CN); CHEN, Xianglong, Beijing Road, China (Shandong) Pilot Free Trade Zone Qingdao Area Qingdao, Shandong 266000 (CN); FAN, Xingzhen, Beijing Road, China (Shandong) Pilot Free Trade Zone Qingdao Area Qingdao, Shandong 266000 (CN); ZHU, Jungao, Beijing Road, China (Shandong) Pilot Free Trade Zone Qingdao Area Qingdao, Shandong 266000 (CN)
(74) Representative: Bergenstråhle & Partners AB
(86) International application number: PCT/CN2024/095451
(87) International publication number: WO 2025/112371

(57) **Abstract**

The present invention discloses a speed control deflection assembly and an ion implanter. The speed control deflection assembly includes a speed control module and a deflection module. The speed control module includes a speed control electrode and a suppression electrode, with the speed control electrode disposed downstream of the suppression electrode. The suppression electrode is used for suppressing upstream beam current electrons and preventing transverse beam current divergence of an upstream ion beam. The speed control electrode has an acceleration mode, a deceleration mode, and a drift mode, and switches between operating modes by adjusting its potential. In the acceleration mode, the ion beam is accelerated to a predetermined energy; in the deceleration mode, the ion beam is decelerated to the predetermined energy; and in the drift mode, the beam current electrons are suppressed to prevent transverse divergence of the ion beam. The deflection module is disposed downstream of the speed control module and is used for deflecting the ion beam processed by the speed control module by a predetermined angle. The ion implanter includes the above speed control deflection assembly. The speed control module has three operating modes, which can be flexibly selected as actually needed. The deflection module can eliminate energy contamination.

## Description

### BACKGROUND OF THE INVENTION

### 1. Technical Field

The present invention belongs to the technical field of semiconductors, and in particular, the present invention relates to a speed control deflection assembly and an ion implanter.

### 2. Description of Related Art

An ion implanter is one of common types of devices in the field of semiconductor element manufacturing. Its primary function is to manipulate doped ions via various electrical and magnetic components, and ultimately implant them into substrate materials to modify the materials. With the continuous advancement of science and technology, importance of ion implantation in the field of semiconductors has become increasingly prominent; and more precise requirements have emerged for an implanted ion energy, a dopant type, a doping depth, an implantation angle, etc. Thus, the design challenges for various components for ion implantation are also growing.

The implantation depth is directly related to the energy of an ion beam. Reducing the ion energy enables a shallow ion implantation, while increasing an ion beam current allows for high-dose implantation. However, a current ion implanter is limited to either acceleration or deceleration solely, and is of an undiversified form. Additionally, energy contamination and thus beam current loss will be caused in acceleration or deceleration of the ion beam.

### BRIEF SUMMARY OF THE INVENTION

### Technical problem

An embodiment of the present invention provides a speed control deflection assembly and an ion implanter. A speed control module has three operating modes, allowing for flexible selection among ion beam acceleration, deceleration, or drift as actually needed. A deflection module is used for deflecting an ion beam by a certain angle, thereby eliminating energy contamination caused by acceleration or deceleration. In a deceleration mode, a drift length of a low-energy beam current is shorter, which helps save a structural space and reduce a low-energy beam current loss. This solves the problems of being limited to either acceleration or deceleration solely, and causing energy contamination and thus beam current loss in acceleration or deceleration of the ion beam of a current ion implanter.

### Technical solution

For this purpose, the embodiment of the present invention provides the following technical solution.

The embodiment of the present invention provides a speed control deflection assembly, including a speed control module and a deflection module.

The speed control module includes a speed control electrode and a suppression electrode, with the speed control electrode disposed downstream of the suppression electrode. The suppression electrode is used for suppressing upstream beam current electrons and preventing transverse beam current divergence of the upstream ion beam. The speed control electrode has an acceleration mode, a deceleration mode, and a drift mode, and switches between operating modes by adjusting its potential. In the acceleration mode, the speed control electrode is used for accelerating the ion beam to a predetermined energy; in the deceleration mode, the speed control electrode is used for decelerating the ion beam to the predetermined energy; and in the drift mode, the speed control electrode is used for suppressing the beam current electrons to prevent transverse divergence of the ion beam.

The deflection module is disposed downstream of the speed control module and is used for deflecting the ion beam processed by the speed control module by a predetermined angle.

Further, an upstream electrode is set as a ground potential of the suppression electrode, and a potential of the suppression electrode is negative relative to the upstream electrode; in the acceleration mode, the earth is set as a ground potential of the speed control electrode, and a potential of the speed control electrode is negative relative to the upstream electrode; in the deceleration mode, the earth is set as the ground potential of the speed control electrode, and the potential of the speed control electrode is positive relative to the upstream electrode; and in the drift mode, the speed control electrode and the suppression electrode are connected to one potential.

Further, the deflection module includes multiple pairs of vertical deflection electrodes and a pair of horizontal focusing electrodes, the multiple pairs of vertical deflection electrodes being arranged back and forth in a horizontal direction, and the horizontal focusing electrodes being disposed between two rows of electrodes arranged vertically among the multiple pairs of vertical deflection electrodes; in the deceleration mode, at least one pair of the multiple pairs of vertical deflection electrodes is used for deflecting a decelerated ion beam; and in the acceleration mode and the drift mode, all the vertical deflection electrodes are used for deflecting the ion beam.

Further, in the deceleration mode, a voltage difference exists between the two electrodes, used for deflecting the ion beam, among the vertical deflection electrodes, while an equal voltage is applied to upper and lower electrodes among the remaining vertical deflection electrodes; and in the acceleration mode and the drift mode, a voltage difference exists between the upper and lower electrodes among all the vertical deflection electrodes.

Further, there are three pairs of vertical deflection electrodes; and in the deceleration mode, a middle pair of the three pairs of vertical deflection electrodes is used for deflecting the decelerated ion beam.

Further, there is an equal horizontal spacing between the three pairs of vertical deflection electrodes; and in the acceleration mode and the drift mode, a same voltage difference exists between the upper and lower electrodes of the front and back pairs of vertical deflection electrodes.

Further, the suppression electrode is in a shape of a plate with a central opening, upper and lower rods disconnected in a vertical direction, or upper and lower bars disconnected in the vertical direction; and the speed control electrode is in the shape of the plate with the opened center, the upper and lower rods disconnected in the vertical direction, or the upper and lower bars disconnected in the vertical direction.

Further, each of the vertical deflection electrodes is in a shape of a circular rod or a square-shaped rod.

Further, each of the horizontal focusing electrodes is in a shape of rods disconnected in the middle or plates disconnected in the middle.

The embodiment of the present invention further provides an ion implanter, including an ion source, a mass analyzer, a focusing device, a parallelization magnet, and the speed control deflection assembly according to the above embodiment.

### The ion source is used for generating an ion beam.

The mass analyzer is disposed downstream of the ion source, and is used for performing mass analysis on the ion beam and screening out ion species required for implantation.

The focusing device is disposed downstream of the mass analyzer, and is used for performing focusing or defocusing to converge or diverge the screened ion beam currents.

The parallelization magnet is disposed downstream of the focusing device, and is used for parallelizing the converged or diverged ion beam.

The speed control deflection assembly is disposed downstream of the parallelization magnet, and is used for accelerating, decelerating, or drifting, as well as deflecting the parallelized ion beam.

### Beneficial Effects

The present invention has the beneficial effects as follows: the speed control module has the three operating modes, allowing for flexible selection among ion beam acceleration, deceleration, or drift as actually needed. The deflection module is used for deflecting the ion beam by the certain angle, thereby eliminating energy contamination caused by acceleration or deceleration. In the deceleration mode, the drift length of the low-energy beam current is shorter, which helps save the structural space and reduce the low-energy beam current loss.

### BRIEF DESCRIPTION OF DRAWINGS

In order to describe the technical solutions in the embodiments of the present invention more clearly, a brief description of the accompanying drawings required for describing the embodiments will be provided below. Obviously, the accompanying drawings in the following description show merely some embodiments of the present invention. Those of ordinary skill in the art can also derive other accompanying drawings from these accompanying drawings described specifically in the embodiments of the present invention below without making creative efforts.
FIG. 1 is a schematic diagram of a speed control deflection assembly according to an embodiment of the present invention;
FIG. 2 is a schematic structural diagram of a speed control module according to an embodiment of the present invention;
FIG. 3 is a schematic structural diagram of a deflection module according to an embodiment of the present invention;
FIG. 4 is a potential wiring diagram according to an embodiment of the present invention;
FIG. 5 is a diagram of an electrode position versus a deflection angle according to an embodiment of the present invention;
FIG. 6 is a schematic diagram of beam current deflection in a drift mode according to an embodiment of the present invention; and
FIG. 7 is a schematic diagram of beam current deflection in a deceleration mode according to an embodiment of the present invention.

### DETAILED DESCRIPTION OF THE EMBODIMENTS

The technical solution of a speed control deflection assembly and an ion implanter provided by various embodiments of the present invention will be clearly and completely described below with reference to the drawings of the specification. Apparently, the described embodiments are only some of the embodiments of the present invention, but not all of the embodiments. On the basis of the embodiments in the present invention, all other embodiments obtained by those of ordinary skill in the art without creative efforts shall fall within the protection scope of the present invention.

In the description of the embodiments of the present invention, it should be understood that the terms "center", "longitudinal direction", "transverse direction", "length", "width", "thickness","up","down", "front", "back", "left", "right", "vertical", "horizontal", "top", "bottom", "inside", "outer", and other directional or positional relationships refer to the orientation or position relationships shown in the accompanying drawings, are used only for the purpose of describing and simplifying the description of the present invention, do not indicate or imply that the device or element referred to must have a specific orientation, be constructed and operated in a particular orientation, and therefore should not be understood as limitations on the embodiments of the present invention. In addition, the terms "first", "second", "third", etc. are merely used for description purposes and cannot be interpreted as indicating or implying relative importance or implicitly indicating the number of technical features indicated. Thus, a feature defined as "first", "second", and "third" may explicitly or implicitly include one or more such features. In the description of the embodiments of the present invention, "a plurality of" means two or more, unless otherwise specifically defined.

In the embodiments of the present invention, unless otherwise clearly specified and limited, the terms "installed", "connected", "connection", "fixed", etc. should be understood broadly. For example, the "connection" may be a fixed connection, a detachable connection, or an integrated connection, may be a mechanical connection or an electrical connection, may be a direct connection or an indirect connection by means of an intermediate medium, or may be an internal connection of two elements or an interaction between two elements, unless otherwise clearly defined. Those of ordinary skill in the art can understand the specific meanings of the above terms in the embodiments of the present invention according to specific situations.

In the embodiments of the present invention, the term "exemplary" is used to mean "used as an example, illustration, or illustration". Any embodiment described as "exemplary" in the embodiments of the present invention is not necessarily to be construed as more preferred or advantageous than other embodiments. For the purpose that any person skilled in the art can implement and use the embodiments of the present invention, the following description is provided. In the following description, the embodiments of the present invention set out details for the purpose of explanation. It should be understood that those of ordinary skill in the art may recognize that the embodiments of the present invention can be implemented even without using these specific details. In other embodiments, well-known structures and processes will not be described in detail to avoid unnecessary details from obscuring the description of the embodiments of the present invention. Therefore, the embodiments of the present invention are not intended to be limited to the illustrated embodiments, but should be consistent with the widest scope consistent with principles and features disclosed by the embodiments of the present invention.

### Embodiment 1:

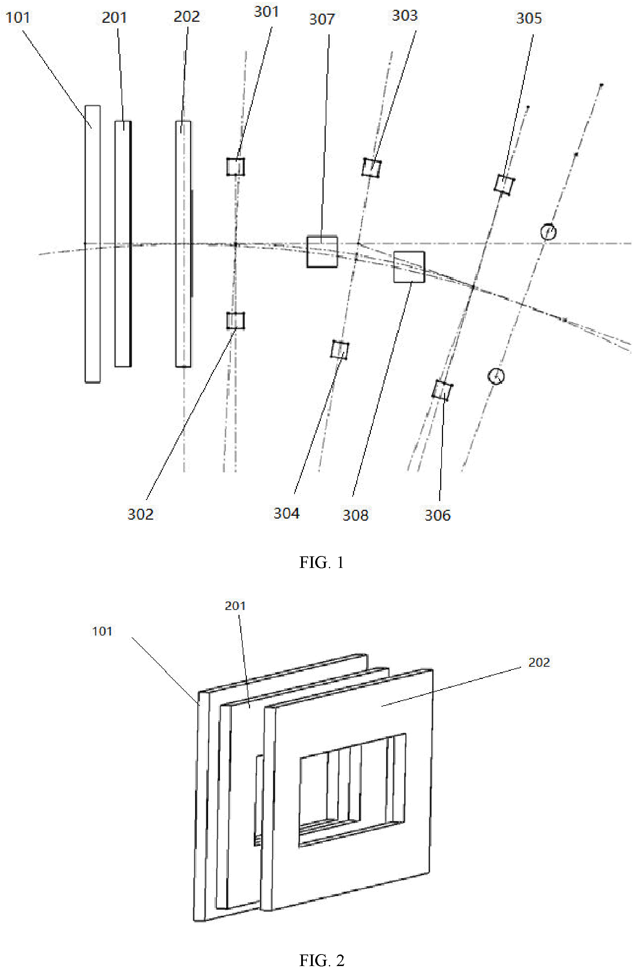

Referring to FIG. 1, FIG. 1 is a schematic diagram of a speed control deflection assembly. This embodiment specifically discloses a speed control deflection assembly, including a speed control module and a deflection module. The speed regulating module is used for adjusting an ion beam to a predetermined energy. As shown in FIG. 1 and FIG. 2, the speed control module includes a speed control electrode 202 and a suppression electrode 201, with the speed control electrode 202 disposed downstream of the suppression electrode 201. The suppression electrode 201 is used for suppressing upstream beam current electrons and preventing transverse beam current divergence of an upstream ion beam. The ion beam is suppressed by the suppression electrode 201, and then enters the speed control electrode 202 for processing. The suppression electrode 201 is in a shape of a plate with a central opening, upper and lower rods disconnected in a vertical direction, or upper and lower bars disconnected in the vertical direction. The speed control electrode 202 is in the shape of the plate with the opened center, the upper and lower rods disconnected in the vertical direction, or the upper and lower bars disconnected in the vertical direction. The suppression electrode 201 and the speed control electrode 202 are shaped according to a layout and a size of an ion implanter. As shown in FIG. 2, in this embodiment, both the suppression electrode 201 and the speed control electrode 202 are in the shape of the plate with the opened center. The ion beam passes through openings in the centers of the suppression electrode 201 and the speed control electrode 202. The speed control electrode 202 has an acceleration mode, a deceleration mode, and a drift mode, and switches between operating modes by adjusting its potential. In the acceleration mode, the speed control electrode 202 is used for accelerating the ion beam to a predetermined energy; in the deceleration mode, the speed control electrode 202 is used for decelerating the ion beam to the predetermined energy; and in the drift mode, the speed control electrode 202 is used for suppressing the beam current electrons to prevent transverse divergence of the ion beam. In acceleration or deceleration, the ion beam will cause energy contamination. As shown in FIG. 1, the deflection module is disposed downstream of the speed control module and is used for deflecting the ion beam processed by the speed control module by a predetermined angle, thereby eliminating energy contamination caused by acceleration or deceleration, and reducing a low-energy beam current loss.

In this embodiment, in the acceleration mode, an upstream electrode is set as a ground potential of the suppression electrode 201, and a potential of the suppression electrode is negative relative to the upstream electrode; the earth is set as a ground potential of the speed control electrode 202, and a potential of the speed control electrode is negative relative to the upstream electrode (i.e. the suppression electrode 201); and in this way, an acceleration objective is achieved. In the deceleration mode, the upstream electrode is set as the ground potential of the suppression electrode 201, and the potential of the suppression electrode is negative relative to the upstream electrode; the earth is set as the ground potential of the speed control electrode 202, and the potential of the speed control electrode is positive relative to the upstream electrode (i.e. the suppression electrode 201); and in this way, a deceleration objective is achieved. In the drift mode, the upstream electrode is set as the ground potential of the suppression electrode 201, and the potential of the suppression electrode is negative relative to the upstream electrode; and the speed control electrode and the suppression electrode 201 are connected to one potential, so as to collectively exert a suppression effect. The operating mode can be switched by adjusting the potential of the speed control electrode, offering a simple and easy-to-operate switching method.

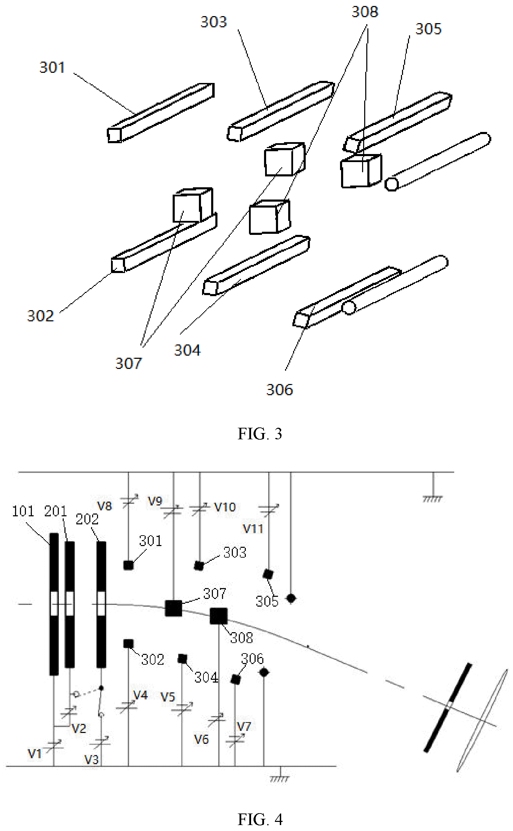

As shown in FIG. 1 and FIG. 3, the deflection module includes multiple pairs of vertical deflection electrodes and a pair of horizontal focusing electrodes; the multiple pairs of vertical deflection electrodes are arranged back and forth in a horizontal direction; there is a horizontal spacing between the vertical deflection electrodes; the horizontal focusing electrodes are disposed between two rows of electrodes arranged vertically among the multiple pairs of vertical deflection electrodes; and the vertical deflection electrodes are used for deflecting an ion beam current by a certain angle. Due to horizontal divergence caused by vertical deflection and a beam current space charge effect, the horizontal focusing electrodes are disposed for controlling a horizontal beam current width, so as to reduce a beam current energy loss in the horizontal direction. A number of the vertical deflection electrodes and the horizontal spacing between them are set according to the actual deflection angle and a requirement for energy intensity elimination. In the deceleration mode, at least one pair of the multiple pairs of vertical deflection electrodes is used for deflecting a decelerated ion beam. In the deceleration mode, the beam current is decelerated to the predetermined energy, with a low beam current energy. Therefore, not all the vertical deflection electrodes are required for angle deflection. The number of the vertical deflection electrodes used for deflecting the ion beam is adjusted according to the decelerated beam current energy. In the acceleration mode and the drift mode, all the vertical deflection electrodes are used for deflecting the ion beam. Due to a high energy of the accelerated and drifting beams, multiple times of deflection are required. Each pair of electrodes offers deflection by the certain angle, ultimately achieving an overall beam current deflection objective and eliminating energy contamination. By selecting the number of the vertical deflection electrodes used for angle deflection and the horizontal spacing between the electrodes, an exit angle and position of the ion beam in each mode can be adjusted. This allows for similar or consistent exit angles and positions of final ion beams in various modes.

Each of the vertical deflection electrodes is in a shape of a circular rod or a square-shaped rod. Each of the horizontal focusing electrodes is in the shape of the rods disconnected in the middle, or the plates disconnected in the middle. Two of the horizontal focusing electrodes are arranged horizontally, and a distance between them is flexibly adjusted according to an actual size and a production requirement of the ion implanter. The shapes of the vertical deflection electrodes and the horizontal focusing electrodes are flexibly selected according on the size and the layout of the ion implanter. The ion beam passes between the upper and lower electrodes of the vertical deflection electrodes and through a self-owned central gap of each of the horizontal focusing electrodes.

In this embodiment, in the deceleration mode, a voltage difference exists between the two electrodes, used for deflecting the ion beam, among the vertical deflection electrodes, while an equal voltage is applied to upper and lower electrodes among the remaining vertical deflection electrodes, which reduces a transmission distance of the low-energy ion beam and provides a corresponding beam current control function. In the acceleration mode and the drift mode, a voltage difference exists between the upper and lower electrodes among all the vertical deflection electrodes; and each pair of electrodes offers deflection by the certain angle, ultimately achieving the overall beam current deflection objective. By adjusting a wiring method of the vertical deflection electrodes to adjust their potential relationship, the deflection angle can be adjusted. A potential of the deflection module is adaptively adjusted according to different operating states of the speed control electrode, and then the deflection angle of the ion beam is adjusted, which can ultimately achieve similar or consistent exit angles and positions of the ion beams in various modes. This operation method is simple.

In this embodiment, as shown in FIG. 1 and FIG. 3, there are three pairs of vertical deflection electrodes; and in the deceleration mode, a middle pair of the three pairs of vertical deflection electrodes is used for deflecting the decelerated ion beam. This is sufficient to meet the requirement for eliminating energy contamination after deceleration. In the acceleration mode and the drift mode, the three vertical deflection electrodes are used for deflecting the ion beam. Each pair of electrodes offers deflection of the beam current by the certain angle, ultimately achieving overall beam current deflection and then eliminating energy contamination after acceleration and drifting.

Further, there is an equal horizontal spacing between the three pairs of vertical deflection electrodes; and in the acceleration mode and the drift mode, a same voltage difference exists between the upper and lower electrodes of the front and back pairs of vertical deflection electrodes. This can ensure consistent exit angles and positions of the ion beams in various modes.

As shown in FIG. 1, the deflection module includes three pairs of vertical deflection electrodes (i.e. A first pair of vertical deflection electrodes 301, 302; a second pair of vertical deflection electrodes 303, 304; and a third pair of vertical deflection electrodes 305, 306) and a central pair of horizontal focusing electrodes 307, 308. The suppression electrode 201 and the speed control electrode 202 are both in the shape of the plate with the opened center for the beam current to pass through. A potential of an electrode 101 is the same as that of the upstream beam current. The electrode 101 is set as the ground potential of the suppression electrode 201, and the potential of the suppression electrode is negative relative to the electrode 101. The potential of the suppression electrode 201 is lower than that of the upstream electrode 101, which can suppress upstream beam current electron from entering a cavity of the speed control deflection assembly, thereby preventing the upstream beam current divergence due to the space charge effect. The potential of the speed control electrode 202 can be set higher than that of the suppression electrode 201, applying a pre-deceleration effect on the ion beam current, which corresponds to the deceleration mode in this embodiment. The potential of the speed control electrode 202 can be set lower than that of the suppression electrode 201, accelerating the beam current, which corresponds to the acceleration mode in this embodiment. The potential of the speed control electrode 202 can also be set same as that of the suppression electrode 201, collectively exerting the suppression effect, which corresponds to the drift mode in this embodiment.

FIG. 4 is a potential wiring diagram according to the present invention. The potential of the electrode 101 is V1; and the potential of the suppression electrode 201, denoted as V2, is below V1, and exerts the electron suppression effect. The potential of the speed control electrode 202 can be connected to V2, exerting the suppression effect together with the suppression electrode 201, which corresponds to the drift mode in this embodiment. Alternatively, it can be connected to V3, which is above V2, providing a pre-deceleration effect, which corresponds to the deceleration mode in this embodiment. Alternatively, it can be connected to V3, which is below V2, providing an acceleration effect, which corresponds to the acceleration mode in this embodiment. In the first pair of vertical deflection electrodes, a potential of the upper electrode 301 is V8, and a potential of the lower electrode 302 is V4. In the drift mode and the acceleration mode, V8 > V4, causing the ion beam to be deflected at the first pair of vertical deflection electrodes. In the deceleration mode, V8 = V4, and the ion beam is not deflected at the first pair of vertical deflection electrodes. In the second pair of vertical deflection electrodes, a potential of the upper electrode 303 is V10, and a potential of the lower electrode 304 is V5. In the drift mode and the acceleration mode, V10 > V5, causing the ion beam to be deflected at the second pair of vertical deflection electrodes. In the deceleration mode, V10 > V5, and the ion beam is also deflected at the second pair of vertical deflection electrodes. In the third pair of deflection electrodes, a potential of the upper electrode 305 is V11, and a potential of the lower electrode 306 is V7. In the drift mode and the acceleration mode, V11 > V7, causing the ion beam to be deflected at the third pair of vertical deflection electrodes. In the deceleration mode, V11 = V7, and the ion beam is not deflected at the third pair of vertical deflection electrodes. A potential of the horizontal focusing electrode 307 is V9, and a potential of the horizontal focusing electrode 308 is V6.

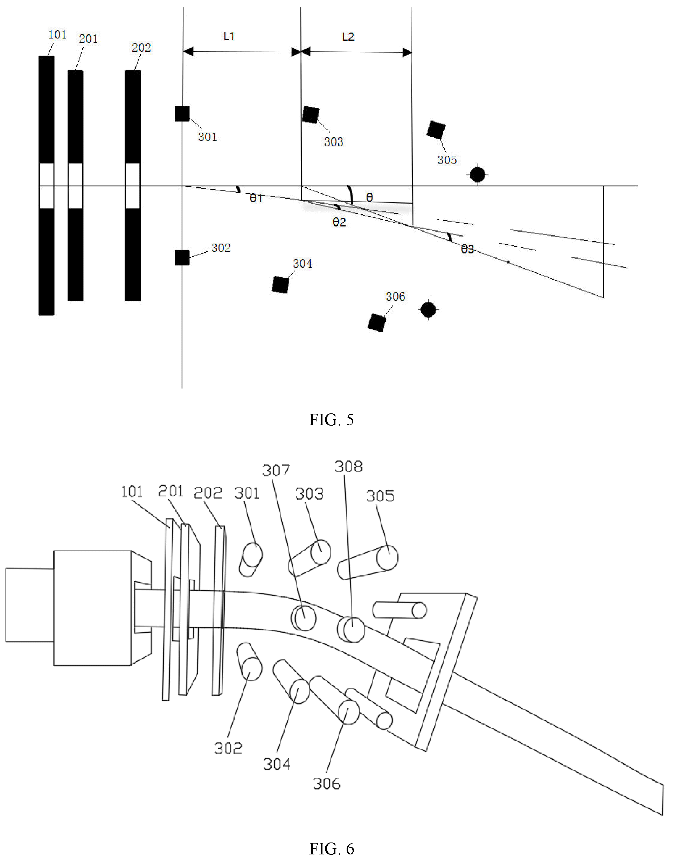

As shown in FIG. 5, in the deceleration mode, after the ion beam current is decelerated to a required energy by the speed control electrode, the same potential is applied to the upper electrode 301 and the lower electrode 302 of the first pair of vertical deflection electrodes. In the second pair of vertical deflection electrodes, the potential of the lower electrode 304 is lower than that of the upper electrode 303, achieving deflection. In the third pair of vertical deflection electrodes, the same potential is also applied to the upper electrode 305 and the lower electrode 306. The beam current travels to the end of L1 with a deflection angle of θ. In the drift mode and the acceleration mode, the beam current has a high energy, and is deflected under the action of the three pairs of vertical deflection electrodes. The deflection angle at the start of L1 is denoted as θ1, at the end of L1 as θ2, and at the end of L2 as θ3. To ensure consistent exit angles and positions of the ion beams in various modes, L1, L2, θ1, θ2, θ3, and θ should satisfy the following equations: $θ 1 + θ 2 + θ 3 = θ$ $L 1 * tan \left(θ1\right) + L 2 * tan \left(θ1+θ2\right) = L 2 * tan \left(θ\right)$

When θ is small (generally smaller than 20°), the following approximate equation can be derived: $L 1 * θ 1 + L 2 * \left(θ1+θ2\right) = L 2 * θ$

Substituting a relationship from equation (1) into equation (3) yields: $L 1 * θ 1 = L 2 * θ 3$

In a special case, L1 can be set equal to L2, which implies θ1 = θ3.

Therefore, the exit angle and position of the ion beam can be adjusted by adjusting positions and potentials of the vertical deflection electrodes, enhancing flexibility of the ion implanter. In this embodiment, adjusting the positions and the potentials of the vertical deflection electrodes can achieve consistent exit angles and positions of the ion beams in various modes, while adjusting the potentials further enables flexible switching between the operating modes and flexible adjustment on the deflection angle. There is an equal horizontal spacing between the three pairs of vertical deflection electrodes. In the deceleration mode, there is a voltage difference only between the middle pair of vertical deflection electrodes. In the acceleration mode and the drift mode, there is a voltage difference between the upper and lower electrodes of each of the three pairs of vertical deflection electrodes. When a same voltage difference exists between the upper and lower electrodes of the front and back pairs of vertical deflection electrodes, it can ensure consistent exit angles and positions of the ion beams in various modes.

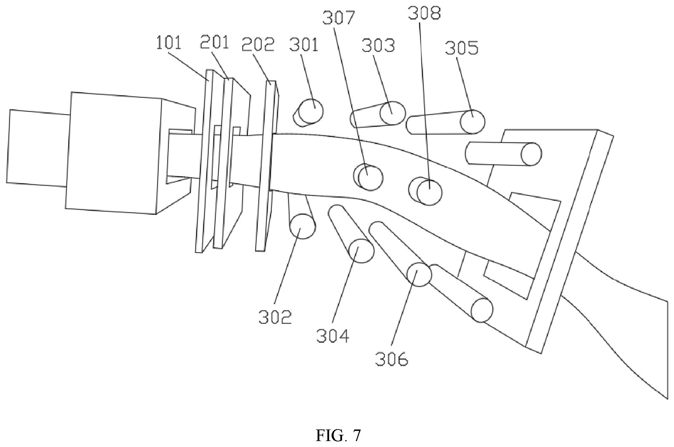

As shown in FIG. 6, in the drift mode, a high-energy beam current completes its trajectory deflection under the action of the three deflection electrodes. As shown in FIG. 7, the high-energy beam current is decelerated by the deceleration module and deflected by the middle vertical deflection electrodes. It is decelerated to a target energy, and beam current deflection is employed to eliminate energy contamination caused by deceleration. The exit angles and positions of the ion beams are consistent in FIG. 6 and FIG. 7. This demonstrates that the speed control deflection assembly in this embodiment can effectively achieve beam current deflection in various modes, thereby eliminating energy contamination caused by acceleration or deceleration, and reducing the low-energy beam current loss.

### Embodiment 2:

Based on the same inventive concept as the first embodiment, this embodiment specifically provides an ion implanter, including an ion source, a mass analyzer, a focusing device, a parallelization magnet, and the speed control deflection assembly according to the above embodiment.

The ion source is used for generating an ion beam, and is capable of producing multivalent ions of boron, phosphorus, arsenic, argon, xenon, or nitrogen.

The mass analyzer is disposed downstream of the ion source, is used for performing mass analysis on the ion beam and screening out ion species required for implantation to ensure purity, and also to provide partial focusing of a transmitted ion beam, thereby improving beam transport efficiency.

The focusing device is disposed downstream of the mass analyzer, and is used for performing focusing or defocusing to converge or diverge the screened ion beam currents, allowing for control on the ion beam size and shaping the ion beam into a required cross-sectional shape. In this embodiment, the focusing device consists of multiple sets of quadrupole lenses.

The parallelization magnet is disposed downstream of the focusing device, and is used for parallelizing the converged or diverged ion beam, so as to bend the deflected ion beam back to be parallel with a preset reference trajectory of the ion beam.

The speed control deflection assembly is disposed downstream of the parallelization magnet, and is used for accelerating, decelerating, or drifting, as well as deflecting the parallelized ion beam, thereby eliminating energy contamination. Finally, the ion beam enters a target chamber.

The ion implanter in this embodiment, by means of the design of the speed control deflection assembly, allows for flexible selection of the operating mode according to an actual production need. In any operating mode, it can eliminate beam current energy contamination. By adjusting potentials and a positional arrangement of the electrodes, consistent exit angles and positions of the ion beams in three operating modes can be achieved, enhancing both use flexibility and ion implantation precision of the ion implanter.

The above descriptions are only preferred embodiments of the present invention, and are not intended to limit the present invention. Any modifications, equivalent replacements, simple improvements etc. made to the substantive content of the embodiments of the present invention shall be included in the protection scope of the present invention.

## Claims

1. A speed control deflection assembly, comprising a speed control module and a deflection module, wherein
the speed control module comprises a speed control electrode and a suppression electrode, with the speed control electrode disposed downstream of the suppression electrode; the suppression electrode is used for suppressing upstream beam current electrons and preventing transverse beam current divergence of the upstream ion beam; the speed control electrode has an acceleration mode, a deceleration mode, and a drift mode, and switches between operating modes by adjusting its potential; in the acceleration mode, the speed control electrode is used for accelerating the ion beam to a predetermined energy; in the deceleration mode, the speed control electrode is used for decelerating the ion beam to the predetermined energy; and in the drift mode, the speed control electrode is used for suppressing the beam current electrons to prevent transverse divergence of the ion beam; and
the deflection module is disposed downstream of the speed control module and is used for deflecting the ion beam processed by the speed control module by a predetermined angle.

2. The speed control deflection assembly according to claim 1, **characterized in that** a upstream electrode is set as a ground potential of the suppression electrode, and a potential of the suppression electrode is negative relative to the upstream electrode; in the acceleration mode, the earth is set as a ground potential of the speed control electrode, and a potential of the speed control electrode is negative relative to the upstream electrode; in the deceleration mode, the earth is set as the ground potential of the speed control electrode, and the potential of the speed control electrode is positive relative to the upstream electrode; and in the drift mode, the speed control electrode and the suppression electrode are connected to one potential.

3. The speed control deflection assembly according to claim 1, **characterized in that** the deflection module comprises multiple pairs of vertical deflection electrodes and a pair of horizontal focusing electrodes, the multiple pairs of vertical deflection electrodes being arranged back and forth in a horizontal direction, and the horizontal focusing electrodes being disposed between two rows of electrodes arranged vertically among the multiple pairs of vertical deflection electrodes; in the deceleration mode, at least one pair of the multiple pairs of vertical deflection electrodes is used for deflecting a decelerated ion beam; and in the acceleration mode and the drift mode, all the vertical deflection electrodes are used for deflecting the ion beam.

4. The speed control deflection assembly according to claim 3, **characterized in that** in the deceleration mode, a voltage difference exists between the two electrodes, used for deflecting the ion beam, among the vertical deflection electrodes, while an equal voltage is applied to upper and lower electrodes among the remaining vertical deflection electrodes; and in the acceleration mode and the drift mode, a voltage difference exists between the upper and lower electrodes among all the vertical deflection electrodes.

5. The speed control deflection assembly according to claim 3, **characterized in that** there are three pairs of vertical deflection electrodes; and in the deceleration mode, a middle pair of the three pairs of vertical deflection electrodes is used for deflecting the decelerated ion beam.

6. The speed control deflection assembly according to claim 5, **characterized in that** there is an equal horizontal spacing between the three pairs of vertical deflection electrodes; and in the acceleration mode and the drift mode, a same voltage difference exists between the upper and lower electrodes of the front and back pairs of vertical deflection electrodes.

7. The speed control deflection assembly according to claim 1, **characterized in that** the suppression electrode is in a shape of a plate with a central opening, upper and lower rods disconnected in a vertical direction, or upper and lower bars disconnected in the vertical direction; and the speed control electrode is in the shape of the plate with the opened center, the upper and lower rods disconnected in the vertical direction, or the upper and lower bars disconnected in the vertical direction.

8. The speed control deflection assembly according to claim 3, **characterized in that** each of the vertical deflection electrodes is in a shape of a circular rod or a square-shaped rod.

9. The speed control deflection assembly according to claim 3, **characterized in that** each of the horizontal focusing electrodes is in a shape of rods disconnected in the middle or plates disconnected in the middle.

10. An ion implanter, comprising an ion source, a mass analyzer, a focusing device, a parallelization magnet, and a speed control deflection assembly according to any one of claims 1 to 9, wherein
the ion source is used to generate ion beams;
the mass analyzer is disposed downstream of the ion source, and is used for performing mass analysis on the ion beam and screening out ion species required for implantation;
the focusing device is disposed downstream of the mass analyzer, and is used for performing focusing or defocusing to converge or diverge the screened ion beam currents;
the parallelization magnet is disposed downstream of the focusing device, and is used for parallelizing the converged or diverged ion beam; and
the speed control deflection assembly is disposed downstream of the parallelization magnet, and is used for accelerating, decelerating, or drifting, as well as deflecting the parallelized ion beam.
